Europäisches Patentamt

European Patent Office

Office européen des brevets

(19)

(11) Publication number: **0 025 950**
**B1**

(12) # EUROPEAN PATENT SPECIFICATION

(45) Date of publication of patent specification: **08.06.83**

(51) Int. Cl.³: **H 03 F 3/72, H 03 F 3/30**

(21) Application number: **80105467.7**

(22) Date of filing: **12.09.80**

(54) **Amplifier device.**

(30) Priority: **19.09.79 JP 120259/79**
**20.11.79 JP 149529/79**

(43) Date of publication of application:
**01.04.81 Bulletin 81/13**

(45) Publication of the grant of the patent:
**08.06.83 Bulletin 83/23**

(84) Designated Contracting States:
**DE FR GB IT NL**

(56) References cited:
**US - A - 3 413 492**
**US - A - 3 454 893**
**US - A - 4 135 162**
**US - A - 4 176 323**

(73) Proprietor: **TOKYO SHIBAURA DENKI KABUSHIKI KAISHA**
**72, Horikawa-cho Saiwai-ku**
**Kawasaki-shi Kanagawa-ken 210 (JP)**

(72) Inventor: **Yamada, Hisashi**
**B-104, Totsukadai-corpo. 2068-1, Totsuka-machi**
**Totsuka-ku Yokohama-shi (JP)**
Inventor: **Sugawara, Tsutomu**
**1489-9, Nagasawa**
**Yokosuka-shi Kanagawa-ken (JP)**

(74) Representative: **Blumbach Weser Bergen Kramer Zwirner Hoffmann Patentanwälte**
**Radeckestrasse 43**
**D-8000 München 60 (DE)**

Amplifier device

This invention relates to an amplifier device according to the prior art portion of claim 1.

An amplifier device of such a kind is shown (US—A—4,135,162) in which the amplifier circuit includes two differential pairs of transistors and a single ended push-pull circuit comprised of two complementary transistor pairs each in Darlington configuration.

Amplifier devices are sometimes required to have muting means which may comprise a muting circuit provided with a field effect transistor (abbreviated as "FET") in order to attenuate signals produced from an amplifier output terminal without cutting off a power supply switch. This muting circuit is formed of the FET and a capacitor connected in series between an amplifier input terminal and a grounding terminal. The gate of the FET is connected to a terminal supplied with a muting-instructing signal (hereinafter referred to as "muting signal terminal") through a muting switch. Where the muting switch is closed and the FET gate is supplied with a muting-instructing signal (hereinafter referred to as "muting signal"), then the FET is rendered conducting. As a result, signals are prevented from being generated from the amplifier output terminal. One reason why the FET is applied is that this type of transistor shows a bidirectional characteristic between the source and drain regions and can be rendered conducting even with respect to signal components having both positive and negative polarities. Another reason for the acceptance of the FET is that it has a far higher linearity of characteristic than the ordinary transistor for use as a variable resistor. In some cases, the FET is connected in series to the input side of the amplifier. However, the conventional amplifier using the FET presents difficulties in being assembled with the mating circuit in a single integrated circuit. Further drawback of the conventional amplifier is that since the amplifier itself is always rendered conducting regardless of whether the muting circuit is or is not actuated, switching noises arising when the FET switch is closed are transmitted to the output terminal of the amplifier device.

A different kind of muting means for amplifier devices is known (US—A—3,413,492 and 3,454,893) in which muting is achieved by switching off a bias current to amplifying elements. In one case (US—A—3,413,492) a pair of differential transistors is provided having their emitters commonly connected to a current source via a strobe pulse controlled switching transistor. In the other case (US—A—3,454,893) a correspondingly pulse controlled switching transistor is connected in parallel to a pair of differential transistors to form a shunt for the bias current when rendered conductive by a corresponding gate pulse.

Because of the leakage path between the output terminal and the input terminal formed by the negative feedback with known amplifier devices having single ended push-pull circuits a sufficient muting function cannot be achieved in devices of this type by cutting off a bias current supply.

The invention as claimed is intended to remedy these drawbacks. It solves the problem of how to design an amplifier device which can carry out muting without using a FET switch in order to avoid transient occurrence of switching noises during the muting mode and which on the other hand does not suffer from an input signal leakage to the output terminal thus improving the muting function.

The problem is solved by having two parallel single ended push-pull circuits operating independently from each other, one supplying the output signal, the other supplying a feedback signal.

This invention can be more fully understood from the following detailed description when taken in conjunction with the accompanying drawings, in which:

Fig. 1 shows the circuit arrangement of an amplifier device according to a first embodiment of this invention;

Fig. 2 indicates the circuit arrangement of an amplifier device according to a second embodiment of the invention.

Fig. 3 sets forth the circuit arrangement of an amplifier device according to a third embodiment of the invention which is additionally provided with a muting control circuit; and

Figs. 4A to 4C are timing charts illustrating the operation of the muting control circuit of Fig. 3.

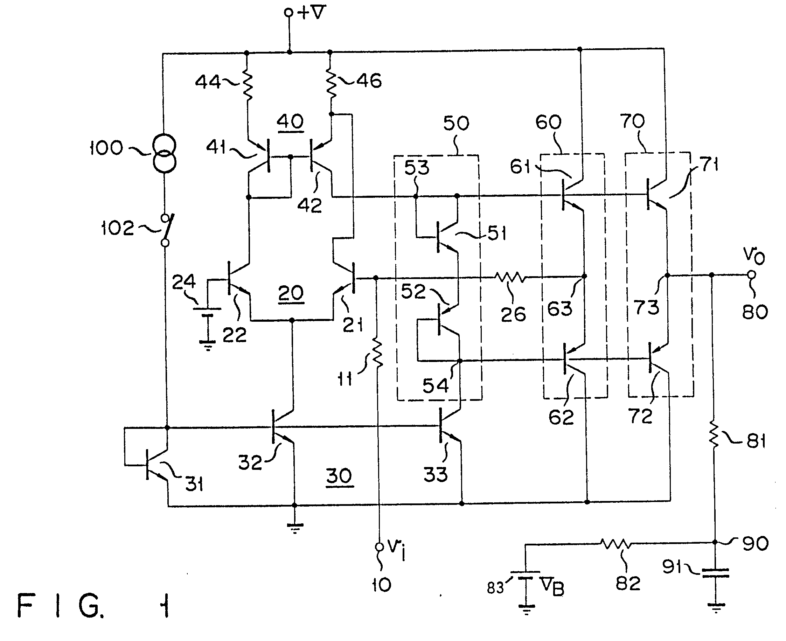

With an amplifier device according to the first embodiment of this invention shown in Fig. 1, an input signal $v_i$ supplied to an input terminal 10 is conducted through a resistor 11 to the base of a transistor 21 which serves as an inverting input of a differential amplifier circuit 20. A reference supply 24 is connected to the base of a transistor 22 which serves as a noninverting input of the differential amplifier circuit 20. The junction of the emitters of the transistors 21, 22 is grounded through the collector-emitter circuit of a constant-current supply transistor 32 constituting part of a power supply circuit 30. The collector of the transistor 22 which serves as an output of the differential amplifier circuit 20 is connected to the input terminal of a current mirror circuit 40 which is formed of transistors 41, 42. The output terminal of the current mirror circuit 40 is connected to a bias circuit 50. The emitters of the transistors 41, 42 are connected to a power source +V through the corresponding resistors 44, 46. The bias circuit 50 is formed of a pair of transistors 51, 52 which are complementary to each other and are connected in series in terms of D.C. The base and collector of the transistor 51 are connected together. The junction 53 of the base and collector is connected to the output terminal of the current mirror circuit 40, or, the collector of the transistor 42. The junction 53 is connected to the base of a transistor 61 constituting a first SEPP circuit 60 component and the base of another transistor 71 constituting a second SEPP circuit 70 component. The base and collector of the remaining transistor 52 of the bias circuit 50 are connected. The junction 54 of the base and collector of transistor 52 is grounded through another constant-current supply transistor 33 of the power supply circuit 30. The junction 54 is further connected to the base of the remaining transistor 62 of the first SEPP circuit component 60 and the base of the remaining transistor 72 of the second SEPP circuit component 70. A pair of diode-connected complementary transistors 61, 62 are connected between the power source +V and earth to constitute the first SEPP circuit component 60. The remaining paired complementary transistors 71, 72 are similarly connected between the power source +V and earth to constitute the second SEPP circuit component 70. The junction 63 of the emitters of the transistors 61, 62 constituting the first SEPP circuit component 60 is connected to the base of the transistor 21 of the differential amplifier circuit 20 through a negative feedback resistor 26. The junction 63 acts as an output for signals sent forth from the first SEPP circuit component 60. The junction 73 of the emitters of the transistors 71, 72 constituting the second SEPP circuit component 70 is connected to an output terminal 80 of the amplifier device, from which a signal $v_0$ is generated. The junction 73 is further connected to the positive pole of a voltage source 83 generating D.C. voltage +$V_B$ through resistors 81, 82. The negative pole of the voltage source 83 is grounded. The junction 90 of the resistors 81, 82 is grounded through a capacitor 91.

A series circuit consisting of a constant-current source 100, muting switch 102 and a transistor 31 of power supply circuit 30 is connected between the power source +V and earth. The constant-current source 100 supplies bias current to the transistors 32, 33 of power supply circuit 30. One of the contacts of the muting switch 102 is connected to the constant-current source 100, and the other contact of the muting switch 102 is connected to the collector and emitter of the transistor 31 and also to the bases of the transistors 32, 33. The emitter of the transistor 31 is grounded.

Where, with an amplifier device according to a first embodiment of this invention shown in Fig. 1, the muting switch 102 is closed, an input signal $v_i$ supplied to the input terminal 10 is amplified by the input stage differential amplifier circuit 20. An output signal from the differential amplifier circuit 20 has its phase inverted by the current mirror circuit 40. The phase-inverted signal is conducted to the bias circuit 50. A current of the same value as the current flowing through the paired transistors 51, 52 constituting the bias circuit flows to the paired transistors 61, 62 constituting the first SEPP circuit component 60 and to the paired transistors 71, 72 constituting the second SEPP circuit component 70. Therefore, the junction 73 of the second SEPP circuit component 70 produces an output signal $v_0$ obtained by amplification of the input signal $v_i$.

Where the muting switch 102 is opened, the transistors 32, 33 are prevented to receive the bias current from the constant-current source 100, and are rendered nonconducting. Where the transistor 33 is rendered nonconducting, no current flows through the transistors 51, 52 of the bias circuit 50, which in turn is cut off. Thus, the transistors 61, 62 of the first SEPP circuit component 60 and the transistors 71, 72 of the second SEPP circuit component 70 are not supplied with current. Consequently, both SEPP circuit components 60, 70 are unactuated, and no signal is supplied to the junctions 63, 73 of the SEPP circuit components 60, 70. Thus, the amplifier device according to the embodiment of this invention shown in Fig. 1 is brought to the muting mode.

During the muting mode, the first and second SEPP circuit components 60, 70 are unactuated. Consequently, the potentials of the junctions 63, 73 of both SEPP circuit components 60, 70 are floating in terms of D.C. and become unstable, giving rise to the occurrence of noise (the so-called pop noise) at the output terminal 80 of the amplifier device. With the first embodiment of Fig. 1, however, the output terminal 80 always receives a predetermined D.C. voltage +$V_B$ from the voltage source 83, and is protected from the occurrence of noise. The capacitor 91 is used to absorb signal components leaking from the voltage source 83.

In the circuit of Fig. 1, the output terminal 80 of the amplifier device is connected to the junction 73 of the second SEPP circuit component 70 and not to the junction 63 of the first SEPP circuit component 60, for the reason given below. The junction 63 of the first SEPP circuit component 60 is connected through a negative feedback resistor 26 to the base of the transistor 21 which serves as the inverting input of the differential circuit 20. The base of the transistor 21 is also connected to the input terminal 10 of the amplifier device through the resistor 11. Even during the muting mode of the amplifier, therefore, the input signal $v_i$ supplied to the input terminal 10 leaks to the junction 63 of the first SEPP circuit component 60 through the resistors 11, 26. If, therefore, the output terminal 80 of the amplifier device were connected to the junction 63 of the first SEPP circuit component 60, the muting function of the subject amplifier device is obstructed by the above-mentioned input signal $v_i$ leaking to the output terminal 63 of the first SEPP circuit component 60. It is for this reason that the output terminal 80 of the amplifier device is connected to the junction 73 of the second SEPP circuit component 70. With the junction 63 of the first SEPP circuit component 60 viewed from the side of the junction 73 of the second SEPP circuit component 70, there are connected between both terminals 63, 73 the transistors 71, 61 whose base-emitter junctions have mutually opposite polarities, and also the transistors 72, 62 whose base-emitter junctions similarly have mutually opposite polarities. Even where, therefore, the voltage of the output terminal 63 of the first SEPP circuit component 60 is changed, at least one backward-biased transistor is always connected between the output terminals 63, 73 of the first and second SEPP circuit components 60, 70. This backward-biased transistor prevents the input signal $v_i$ supplied to the input terminal 10 of the amplifier device, leaking to the junction 63 of the first SEPP circuit component 60, from being further transmitted to the output terminal 73 of the second SEPP circuit component 70. During the muting mode of an amplifier device according to the first embodiment of Fig. 1, therefore, signals are fully attenuated while flowing through a passage defined between the input terminals 10 and output terminal 80 of the amplifier device.

The amplifier device according to the first embodiment of Fig. 1 has the advantages that an output stage SEPP circuit concurrently acts as a switching circuit for the muting of the amplifier device, thereby dispensing with the FET used in the conventional amplifier device, enabling the whole of the amplifier device to be easily assembled in a single integrated circuit. And during the muting mode of the amplifier device, the SEPP circuit is unactuated, thereby preventing transient noise arising at the opening of the muting switch 102 from being transmitted to the output terminal 80 of the amplifier device.

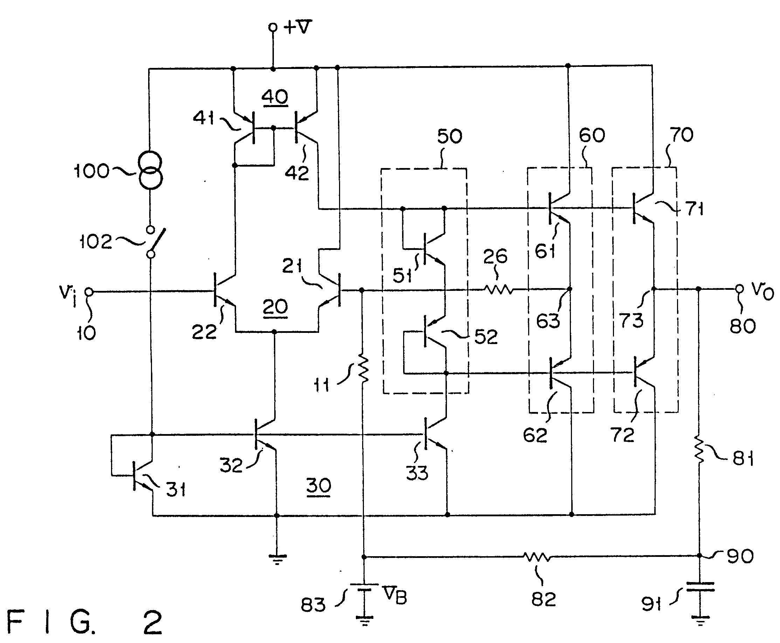

Description is now given with reference to Fig. 2 of an amplifier device according to a second embodiment of this invention. The base of the transistor 22 which serves as the noninverting input of the differential amplifier circuit 20 is connected to the input terminal 10 of the subject amplifier device. The base of transistor 21 which serves as the inverting input of the differential amplifier circuit 20 is connected to the positive pole of the voltage source 83 through the resistor 11. The other parts of the second embodiment of Fig. 2 are the same as those of the first embodiment of Fig. 1. With the second embodiment arranged as described above, an input signal $v_i$ supplied to the input terminal 10 of the amplifier device does not theoretically tend to leak to the junction 63 of the first SEPP circuit component 60. Actually, however, signal current delivered from the outside of the amplifier device is likely to arise in the power supply circuit. These external signal current is conducted from the voltage souce 83 through the resistors 11, 22 and leak to the junction 63 of the first SEPP circuit component 60. If, therefore, the output terminal 80 of the amplifier device is connected to the junction 63, then muting cannot be effected with the attenuation degree of, for example, −80 dB. With the second embodiment of Fig. 2, therefore, the output terminal 80 of the amplifier device is connected to the junction 73 of the second SEPP circuit component 70 for the reason given above as in the case of the first embodiment of Fig. 1.

With the second embodiment of Fig. 2, the base of the transistor 22 of the differential amplifier circuit 20 is connected to the input terminal 10, dispensing with the reference supply 24 used in the first embodiment of Fig. 1. Therefore, the whole circuit arrangement of the second embodiment is further simplified, offering advantage in assembling an amplifier device in an integrated circuit.

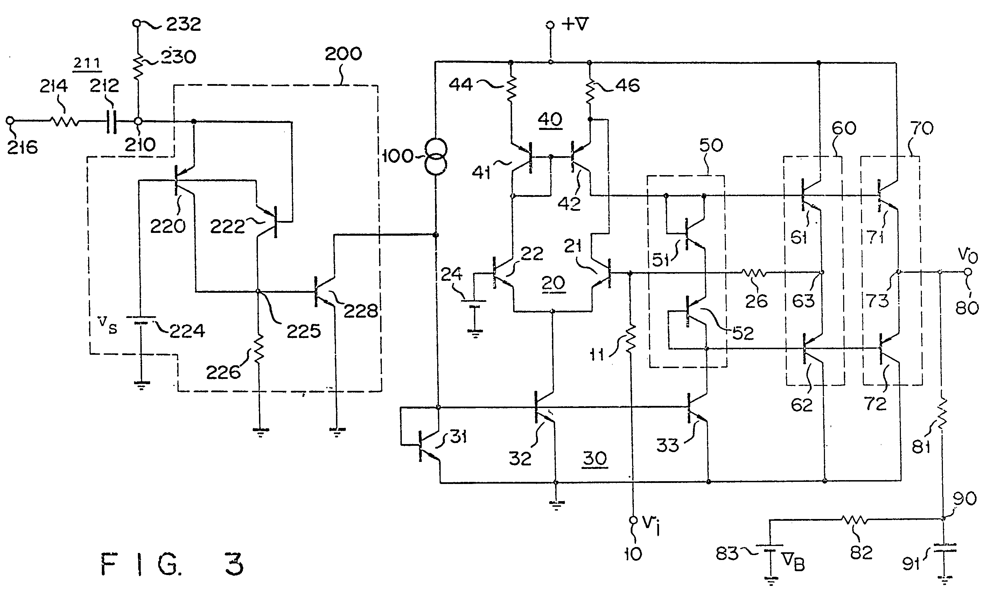

An amplifier device according to a third embodiment of this invention shown in Fig. 3, lacks a muting switch 102 disposed between the constant-current source 100 and transistor 31 of the first embodiment of Fig. 1. A muting control circuit 200 is connected to the junction of base and collector of the transistor 31. The input terminal 210 of the muting control circuit 200 is connected to a first terminal 216 through a capacitor 212 and a resistor 214. This first terminal 216 is further connected to a recording-reproduction changeover switch (not shown) used, for example, with a tape recorder. The first terminal 216 is supplied with a signal for actuating the changeover switch (hereinafter referred to as "changeover switch signal"). The changeover switch signal is transmitted to the muting control circuit 200 through a differentiating circuit 211 and input terminal 210. The input terminal 210 is connected to the emitter of a first wave-detecting transistor 220 and the base of a second wave-detecting transistor 222. The base of the first wave-detecting transistor 220 and the emitter of the second wave-detecting transistor 222 are impressed with voltage $V_s$ from a bias source 224. The collectors of the transistors 220, 222 are connected together. A collector junction 225 is grounded through a resistor 226 and connected to the base of a third output transistor 228. The emitter of this third output transistor 228 is grounded, and the collector thereof is connected to the junction of base and collector of the transistor 31. The input terminal 210 of the muting control circuit 200 is connected to a second terminal 232 through a resistor 230, and further to a steady-state muting switch (not shown).

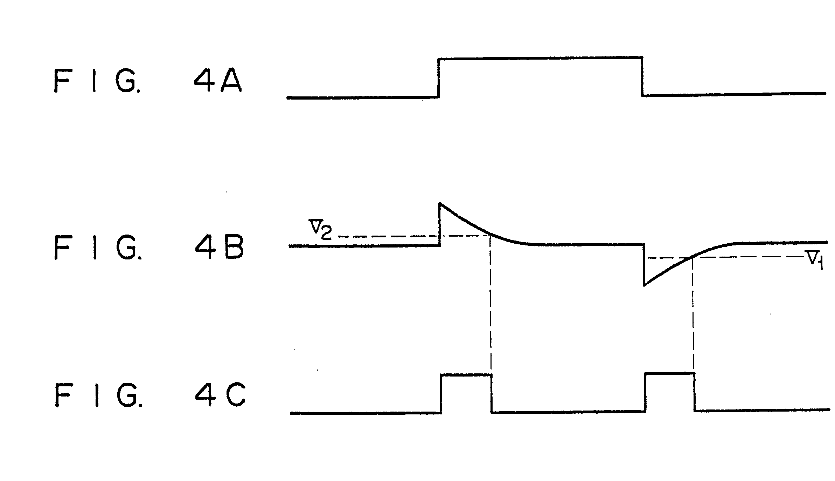

Where, with an amplifier device according to the third embodiment of Fig. 3 constructed as described above, a signal illustrated, for example, in Fig. 4A is supplied to the first terminal 216, then this signal is differentiated by the differentiating circuit 211 to be converted into a signal shown in Fig. 4B. Where the differentiated signal is conducted to the input terminal 210 of the muting control circuit 200, then the muting control circuit 200 generates a pulse signal illustrated in Fig. 4C where the input voltage having a differentiated waveform has a level lower than a predetermined lower voltage $V_1$ and higher than a predetermined upper voltage $V_2$ (where $V_2 > V_1$). If, in case the base-emitter voltage of both first and second transistors 220, 222 stands at 0.5 volt, the input terminal 210 is impressed with a voltage whose level is lower than $V_1 = V_s - 0.5$ volts, then the second transistor 222 is rendered conducting, causing a muting control signal illustrated in Fig. 4C to appear in the base of the transistor 228. Where the input terminal 210 is supplied with a voltage whose level is higher than $V_2 = V_s + 0.5$ volts, then the first transistor 220 is rendered conducting, causing a muting control signal shown in Fig. 4C to appear in the base of the transistor 228. The transistor 228 is rendered conducting in response to the control signal, thereby all the current supplied from the constant-current source 100 flows into ground through the transistor 228. Since, at this time, the constant-current supply transistors 32, 33 are rendered nonconducting, transient noises occurring, for example, when the recording-reproduction changeover switch is opened or closed are prevented from being transmitted to the output terminal 80 of the amplifier device. To ensure the above-mentioned muting operation, the voltage $V_2$ should be as high as 0.1 to 1 volt than the voltage $V_1$. With an amplifier device according to the embodiment of Fig. 3, a second terminal 232 is connected to an input terminal 210 of the muting control circuit 200 through a resistor 230. Where the second terminal 232 is supplied with a muting signal having a voltage level lower than $V_1$ or higher than $V_2$ by a steady-state muting switch (not shown) for a prescribed length of time, then the amplifier reliably carries out regular muting. This steady-state muting can be controlled only by the input terminal 210 of the muting control circuit 200, thereby simplifying its arrangement.

Where, with the embodiment of Fig. 3, the muting control circuit 200 is supplied with an input signal having a waveform representing a lower voltage level than the prescribed level $V_1$, then a muting control signal always appears in the collector of a third transistor 228 of the muting control circuit 200. Even where, therefore, an input voltage is temporarily changed from the zero volt to the steady-state voltage level by power supply to the amplifier device, then the muting control circuit 200 never fails to be rendered conducting at least once to send forth a muting control signal. As a result, the amplifier carries out muting, thereby suppressing the occurrence of noises at power supply to the amplifier.

Although the present invention has been shown and described with respect to particular embodiments, various changes and modifications which are obvious to a person skilled in the art to which the invention pertains are deemed to be included in the invention. Referring to the embodiment of Fig. 3, the input terminal 210 of the muting control circuit 200 is connected to a single differentiating circuit 211 and a single terminal 216. However, the input terminal 210 may be connected to a plurality of parallel connected series circuits each formed of one differentiating circuit and one terminal. This modification enables the single input terminal 210 of the muting control circuit 200 to be supplied with a large number of switch changeover signals at the same time, without the arrangement of said muting control circuit 200 being complicated.

## Claims

1. An amplifier, comprising an amplifier circuit (20) having an input (10) to receive an electrical input signal, a current mirror circuit (40) connected to said amplifier circuit (20), single ended push-pull means (60, 70) for amplifying the electrical input signal and bias circuit means (50) for supplying bias to said single ended push-pull means (60, 70), characterized in that muting means (102; 200) are provided for stopping the supply of current from a current source (100) at least to said bias circuit means (50) and for muting an output signal generated from an output (80) of the amplifier and that said single ended push-pull means includes a plurality of single ended push-pull circuits including at least first and second single ended push-pull circuits (60, 70) connected in parallel to each other, said first single ended push-pull circuit (60) includes a pair of series-connected complementary transistors (61, 62) having emitter electrodes which are connected to each other and which are connected to said amplifier circuit (20), and said second single-ended push-pull circuit (70) includes a pair of series-connected complementary transistors (71, 72) having emitter electrodes which are connected to each other, which are electrically insulated from the emitter electrodes of the transistors (61, 62) of said first single ended push-pull circuit (60) and which are connected to the output (80) of said amplifier.

2. An amplifier as claimed in claim 1, characterized in that said amplifier circuit (20) includes a differential pair of transistors (21, 22) having the same conductivity type, one transistor having a base electrode to which a predetermined voltage is supplied and the other transistor having a base electrode connected to said input (10) to which the electrical input signal is supplied.

3. An amplifier (Fig. 1) as claimed in claim 2, characterized in that the emitter electrodes of the transistors (61, 62) of said first single ended push-pull circuit (60) are connected to the base electrode of said other transistor (21) of said amplifier circuit (20).

4. An amplifier (Fig. 2) as claimed in claim 2, characterized in that the emitter electrodes of the transistors (61, 62) of said first single ended push-pull circuit (60) are connected together to the base electrode of said one transistor (21) of said amplifier circuit (20).

5. An amplifier (Fig. 2) as claimed in claim 2, characterized by further comprising a voltage source means (83), connected to the base electrode of said one transistor (21) of said amplifier circuit (20) and the output (80), for supplying reference voltage having a predetermined level to the base electrode of said one transistor (21) and said output terminal (80).

6. An amplifier (Fig. 3) as claimed in claim 1, characterized in that said muting means includes muting control means (200, 211) connected to the output terminal of the current source (100) for differentiating an external pulse signal and for cutting off the supply of current at least to said bias circuit (50) from said current source (100) when the potential of the differentiated signal is out of the range of a predetermined voltage level.

7. An amplifier as claimed in claim 6, characterized in that said muting control means comprises a differentiating circuit (211) for differentiating the external pulse signal, and a muting control circuit (200) including a switching transistor (228) provided between said current source (100) and a ground which conducts when a voltage level is lower than a predetermined voltage ($V_1$) or higher than a voltage ($V_2$) set at a higher level than said voltage ($V_1$), thereby making the current flow from said current source (100) to the ground.

8. An amplifier as claimed in claim 7, characterized in that said differentiating circuit (211) includes a series circuit of a resistor (214) and capacitor (212).

9. An amplifier as claimed in claim 7, characterized in that said muting control circuit (200) includes a first detecting transistor (220) of a predetermined conductivity type having a collector electrode, a base electrode supplied with a bias voltage and en emitter electrode supplied with said differentiated signal; a second detecting transistor (222) having a base electrode supplied with said differentiated signal, an emitter electrode supplied with said bias voltage and a collector electrode connected to the collector of said first detecting transistor (220), and which is of the same conductivity type as that of said first detecting transistor (220), the collector electrodes of said first and second detecting transistors (220, 222) being connected to the base electrode of said switching transistor (228).

10. An amplifier as claimed in claim 9, characterized in that said muting control circuit (200) has a single input (210), connected to a terminal (232) to which a muting signal produced by an external steady-state muting switch is supplied for a prescribed length of time, whereby said amplifier carries out a regular muting function.

**Patentansprüche**

1. Verstärker, umfassend eine Verstärkerschaltung (20) mit einem Eingang (10) zum Empfang eines elektrischen Eingangssignals, eine mit der Verstärkerschaltung (20) verbundene Stromspiegelschaltung (40), eine Gegentaktanordnung (60, 70) mit Eintaktausgang zur Verstärkung des elektrischen Eingangssignals, und eine Vorspannungseinrichtung (50) zur Lieferung einer Vorspannung an die Gegentaktanordnung (60, 70) mit Eintaktausgang, dadurch gekennzeichnet, daß eine Stummschalteinrichtung (102; 200) zur Unterbrechung der Stromzufuhr von einer Stromquelle (100) wenigstens an die Vorspannungseinrichtung (50) und zur Dämpfung eines vom Ausgang (80) des Verstärkers erzeugten Ausgangssignals vorgesehen ist, und daß die mit Eintaktausgang versehene Gegentaktanordnung eine Vielzahl von mit Eintaktausgang versehenen Gegentaktschaltungen mit wenigstens einer ersten und einer zweiten mit Eintaktausgang versehenen Gegentaktschaltung (60, 70) aufweist, die parallel zueinander geschaltet sind, wobei die erste mit Eintaktausgang versehene Gegentaktschaltung (60) ein Paar reihengeschalteter komplementärer Transistoren (61, 62) aufweist, deren Emitterelektroden miteinander und mit der Verstärkerschaltung (20) verbunden sind, während die zweite mit Eintaktausgang versehene Gegentaktschaltung (70) ein Paar von reihengeschalteten komplementären Transistoren (71, 72) aufweist, deren Emitterelektroden miteinander verbunden sind, von den Emitterelektroden der Transistoren (61, 62) der ersten mit Eintaktausgang versehenen Gegentaktschaltung (60) elektrisch isoliert sind und mit dem Ausgang (80) des Verstärkers verbunden sind.

2. Verstärker nach Anspruch 1, dadurch gekennzeichnet, daß die Verstärkerschaltung (20) ein Transistorpaar (21, 22) gleichen Leitungstyps in Differenzschaltung besitzt, von denen der eine Transistor eine Basiselektrode aufweist, an die eine vorbestimmte Spannung angelegt ist, während der andere Transistor eine Basiselektrode aufweist, die mit dem Eingang (10), dem das elektrische Eingangssignal zugeführt wird, verbunden ist.

3. Verstärker (Fig. 1) nach Anspruch 2, dadurch gekennzeichnet, daß die Emitterelektroden der Transistoren (61, 62) der ersten

mit Eintaktausgang versehenen Gegentaktschaltung (60) mit der Basiselektrode des anderen Transistors (21) der Verstärkerschaltung (20) verbunden sind.

4. Verstärker (Fig. 2) nach Anspruch 2, da-durch gekennzeichnet, daß die Emitter-elektroden der Transistoren (61, 62) der ersten mit Eintaktausgang versehenen Gegentaktschaltung (60) zusammen an die Basiselektrode des einen Transistors (21) der Verstärkerschaltung (20) angeschlossen sind.

5. Verstärker (Fig. 2) nach Anspruch 2, dadurch gekennzeichnet, daß er weiterhin eine Spannungsquelleneinrichtung (83) aufweist, die mit der Basiselektrode des einen Transistors (21) der Verstärkerschaltung (20) und dem Ausgang (80) verbunden ist, um eine Bezugsspannung einer vorbestimmten Höhe an die Basiselektrode des einen Transistors (21) und den Ausgangsanschluß (80) anzulegen.

6. Verstärker (Fig. 3) nach Anspruch 1, da-durch gekennzeichnet, daß die Stummschalt-einrichtung eine Stummschaltsteuereinrich-tung (200, 211) umfaßt, die mit dem Ausgangsanschluß der Stromquelle (100) verbunden ist und ein externes Impulssignal differenziert und die Stromzufuhr von der Stromquelle (100) we-nigstens zur Vorspannungsschaltung (50) unter-bricht, wenn das Potential des differenzierten Signals außerhalb des Bereichs einer vorgegebenen Spannungshöhe liegt.

7. Verstärker nach Anspruch 6, dadurch ge-kennzeichnet, daß die Stummschaltsteuerein-richtung eine Differenzierschaltung (211) zum Differenzieren des externen Impulssignals und eine Stummschaltsteuerschaltung (200) aufweist, die eine zwischen der Stromquelle (100) und einem Massepunkt vorgesehenen Schalttransistor (228) umfaßt, der leitet, wenn ein Spannungswert niedriger als eine vorbe-stimmte Spannung ($V_1$) oder höher als eine Spannung ($V_2$), die auf einen höheren Wert als die Spannung ($V_1$) eingestellt ist, ist, um dadurch den Stromfluß von der Stromquelle (100) nach Masse abzuleiten.

8. Verstärker nach Anspruch 7, dadurch ge-kennzeichnet, daß die Differenzierschaltung (211) eine Reihenschaltung aus einem Widerstand (214) und einem Kondensator (212) umfaßt.

9. Verstärker nach Anspruch 7, dadurch ge-kennzeichnet, daß die Stummschaltsteuer-schaltung (200) umfaßt: einen ersten Meß-transistor (220) eines vorbestimmten Leitungs-typs, der eine Kollektorelektrode, eine mit einer Vorspannung beaufschlagte Basiselektrode und eine mit dem differenzierten Signal beaufschlagte Emitterelektrode besitzt; einen zweiten Meßtransistor (222), der eine mit dem differenzierten Signal beaufschlagte Basiselektrode, eine mit der Vorspannung beaufschlagte Emitterelektrode und eine mit dem Kollektor des ersten Meßtransistors (220) verbundene Kollektorelektrode besitzt und denselben Leitungstyp wie der erste Meßtransistor (220) aufweist, wobei die Kollektorelektrode des ersten Meßtransistors (220) und die des zweiten Meßtransistors (222) mit der Basiselektrode des Schalttransistors (228) verbunden sind.

10. Verstärker nach Anspruch 9, dadurch ge-kennzeichnet, daß die Stummschaltsteuer-schaltung (200) einen einzigen Eingang (210) aufweist, der mit einem Anschluß (232) verbunden ist, an den ein von einem externen der Erzeugung eines stationären Stummschaltssignals dienenden Stummschalter erzeugtes Stummschaltssignal für eine vorgeschriebene Zeitdauer angelegt wird, wodurch der Ver-stärker eine reguläre Stummschaltfunktion aus-führt.

**Revendications**

1. Amplificateur, constitué par un circuit amplificateur (20) comprenant une entrée (10) pour recevoir un signal d'entrée électrique, un circuit miroir de courant (40) connecté audit circuit amplificateur (20) un amplificateur symétrique à une seule borne (60, 70) pour amplifier le signal d'entrée électrique et un circuit de polarisation (50) pour fournir une polarisation audit amplificateur symétrique à une seule borne (60, 70), caractérisé en ce qu'un dispositif de silence (102; 200) est prévu pour interrompre la fourniture de courant par une source de courant (100) au moins audit circuit de polarisation (50) et pour rendre silencieux un signal de sortie produit par une sortie (80) de l'amplificateur, et que ledit amplificateur symétrique à une seule borne comporte plusieurs circuits amplificateurs symétriques à une seule borne comprenant au moins des premier et second circuits amplificateurs symétriques et une seule borne (60, 70) connectés en parallèle entre eux, ledit premier circuit amplificateur symétrique à une seule borne (60) comprenant une paire de transistors complémentaires connectés en série (61, 62) dont les électrodes d'émetteur sont connectées entre elles et connectées audit circuit amplificateur (20), et lesdits second circuit amplificateur symétrique à une seule borne (70) comprenant une paire de transistors complémentaires (71, 72) connectés en série dont les électrodes d'émetteur sont connectées entre elles, qui sont électriquement isolées des électrodes d'émetteur du transistor (61, 62) dudit premier circuit amplificateur symétrique à une seule borne (60) et qui sont connectés à la sortie (80) dudit amplificateur.

2. Amplificateur selon la revendication 1, caractérisé en ce que ledit circuit amplificateur (20) comporte une paire différentielle de transistors (21, 22) ayant le même type de conductivité, un transistor ayant une électrode de base à laquelle une tension prédéterminée est appliquée et l'autre transistor ayant une électrode de base connectée à ladite entrée (10) à laquelle ledit signal d'entrée électrique est appliqué.

3. Amplificateur (Fig. 1) selon la revendication 2, caractérisé en ce que les électrodes d'émetteur des transistors (61, 62) dudit premier circuit amplificateur symétrique à une seule borne (60) sont connectées à l'électrode de base dudit autre transistor (21) dudit circuit amplificateur (20).

4. Amplificateur (Fig. 2) selon la revendication 2, caractérisé en ce que les électrodes d'émetteur des transistors (61, 62) dudit premier circuit amplificateur symétrique à une seule borne (60) sont connectées ensemble à l'électrode de base dudit transistor (21) dudit circuit amplificateur (20).

5. Amplificateur (Fig. 2) selon la revendication 2, caractérisé en ce qu'il comporte en outre une source de tension (83) connectée à l'électrode de base dudit transistor (21) dudit circuit amplificateur (20) et à la sortie (80) pour fournir une tension de référence ayant un niveau prédéterminé à l'électrode de base dudit transistor (21) et à ladite borne de sortie (80).

6. Amplificateur (Fig. 3) selon la revendication 1, caractérisé en ce que ledit dispositif de silence comporte un dispositif de commande de silence (200, 211) connecté à la borne de sortie de la source de courant (100) pour différencier un signal pulsé extérieur et pour couper la fourniture de courant au moins audit circuit de polarisation (50), à partir de ladite source de courant (100) quand le potentiel dudit signal différencié et en dehors de la plage d'un niveau de tension prédéterminé.

7. Amplificateur selon la revendication 6, caractérisé en ce que ledit dispositif de commande de silence consiste en un circuit différenciateur (211) destiné à différencier le signal pulsé extérieur, et en un circuit de commande de silence (200) comprenant un transistor de commutation (228) prévu entre ladite source de courant (100) et une masse, qui conduit quand un niveau de tension est inférieur à une tension prédéterminée ($V_1$) ou supérieur à une tension ($V_2$) établie à un niveau supérieur à ladite tension ($V_1$), de manière que le courant circule dans ladite source de courant (100) vers la masse.

8. Amplificateur selon la revendication 7, caractérisé en ce que ledit circuit différenciateur (211) comporte un circuit en série d'une résistance (214) et d'un condensateur (212).

9. Amplificateur selon la revendication 7, caractérisé en ce que ledit circuit de commande de silence (200) comporte un premier transistor de détection (220) d'un type de conductivité prédéterminé comprenant une électrode de collecteur, une électrode de base qui reçoit une tension de polarisation et une électrode d'émetteur qui reçoit ledit signal différencié, un second transistor de détection (222) ayant une électrode de base qui reçoit ledit signal différencié, une électrode d'émetteur qui reçoit ladite tension de polarisation et une électrode de collecteur connectée au collecteur dudit premier transistor de détection (220) et qui est du même type de conductivité que celui dudit premier transistor de détection (220), les électrodes de collecteur desdits premier et second transistors de détection (220, 222) étant connectées à l'électrode de base dudit transistor de commutation (228).

10. Amplificateur selon la revendication 9, caractérisé en ce que ledit circuit de commande de silence (200) comporte une seule entrée (210) connectée à une borne (232) à laquelle un signal de silence produit par un commutateur de silence normal extérieur est appliqué pendant une durée prédéterminée, de manière que ledit amplificateur remplisse une fonction de silence régulière.

F I G. 1

F I G. 2

F I G. 3

0 025 950

F I G.    4 A

F I G.    4 B

F I G.    4 C